# FASCICULE DE BREVET EUROPEEN

(11) **EP 2 365 743 B1**
(45) Date de publication et mention de la délivrance du brevet: **19.07.2017**
(21) Numéro de dépôt: 11157130.3
(22) Date de dépôt: 07.03.2011
(51) Int. Cl.: H05K 3/40, H01L 21/60, H01L 21/768, H01L 23/48

(54) **Structure d'interconnexion comprenant des vias borgnes destinés à être métallisés**
Verbindungsstruktur, die Sacklöcher umfasst, die metallisiert werden sollen
Interconnection structure including blind via holes intended for being metallised

(30) Priorité: 10.03.2010 FR 1051727
(43) Date de publication de la demande: 14.09.2011
(73) Titulaire: Commissariat à l'Énergie Atomique et aux Énergies Alternatives, 75015 Paris (FR)
(72) Inventeur: Saint-Patrice, Damien, 26120, CHABEUIL (FR); Bolis, Sébastien, 38920, CROLLES (FR); Jacquet, Fabrice, 38220, SAINT PIERRE DE MESAGE (FR)
(74) Mandataire: Ilgart, Jean-Christophe

(56) Documents cités:
- JP-A- 2003 124 380
- US-A1- 2006 205 211

## Description

### DOMAINE TECHNIQUE

L'invention concerne le domaine des dispositifs microélectroniques comprenant un ou plusieurs vias borgnes à métalliser.

L'invention concerne plus particulièrement une structure d'interconnexion comportant plusieurs vias borgnes destinés à être métallisés, par exemple lors d'une même étape de métallisation.

L'invention pourra être utilisée en microélectronique pour la réalisation d'interconnexions électriques et/ou de reprises de contacts électriques dans une structure d'interconnexion comprenant un substrat, ou wafer, microélectronique, c'est-à-dire servant de support pour la réalisation d'un ou plusieurs circuits électroniques reliés électriquement aux interconnexions et/ou aux contacts électriques.

L'invention est particulièrement adaptée pour réaliser une ou plusieurs interconnexions électriques entre deux substrats par la métallisation d'un ou plusieurs vias borgnes formés dans au moins un des deux substrats, ou encore pour réaliser une reprise de contacts électriques dans un dispositif microélectronique tel qu'un dispositif imageur.

### ÉTAT DE LA TECHNIQUE ANTÉRIEURE

Il est connu de réaliser des interconnexions électriques ou des reprises de contacts électriques dans un substrat en formant des vias, c'est-à-dire des trous ou des cavités, dans ce substrat, puis en réalisant une métallisation de ces vias, c'est-à-dire en les remplissant avec un matériau électriquement conducteur tel que du métal.

Une telle métallisation de vias formés dans un substrat peut être obtenue en mettant en oeuvre des procédés classiques de dépôt sous vide, par exemple de type PVD (dépôt physique en phase vapeur), PECVD (dépôt chimique en phase vapeur assisté par plasma), électrolyse, etc. Ces procédés sont adaptés pour métalliser des vias de faibles diamètres, par exemple inférieurs à environ 100 µm, et de faibles profondeurs.

Toutefois, ces procédés deviennent inappropriés lorsque l'on souhaite métalliser des vias de plus grandes profondeurs, par exemple dans le cas de vias traversant réalisés dans toute l'épaisseur d'un substrat semi-conducteur tel que du silicium dont l'épaisseur standard est égale à environ 720 µm, et cela même pour des vias comprenant des motifs de grandes dimensions, c'est-à-dire comprenant un diamètre supérieur ou égal à environ 200 µm, en raison des temps de mise en oeuvre nécessaires extrêmement longs, et donc du coût de revient pour réaliser de telles métallisations.

Afin de réduire ce coût, il est également connu de réaliser une métallisation de vias par sérigraphie : le matériau électriquement conducteur est disposé sur le substrat sous la forme d'une pâte puis, par l'intermédiaire d'une racle, cette pâte est introduite dans les vias.

Cependant, une telle métallisation par sérigraphie pose des problèmes dans le cas de vias dits « borgnes », c'est-à-dire de vias non traversant qui débouchent au niveau d'une seule face du substrat et qui comportent une paroi de fond formée soit dans le substrat soit par un second substrat solidarisé au premier substrat. Les défauts les plus fréquents alors rencontrés sont l'emprisonnement de bulles d'air dans les vias, sous le matériau électriquement conducteur, et/ou le remplissage partiel des vias empêchant de réaliser une reprise des contacts électriques formés par les vias du côté des parois de fond des vias.

Pour palier à ces problèmes, le document JP 2002/144523 A propose de réaliser une métallisation de vias par la mise en oeuvre d'une sérigraphie sous vide. Toutefois, les inconvénients liés à la mise en oeuvre d'une telle sérigraphie sous vide sont nombreux :
- les modifications devant être apportées au matériel de sérigraphie pour réaliser une telle sérigraphie sous vide sont très coûteuses,
- le temps nécessaire à la mise sous vide du substrat avant de procéder à la sérigraphie est important,
- le matériau de sérigraphie utilisé pour métalliser les vias doit être compatible avec une mise sous vide, ce qui impose d'utiliser un composite polymère/métal comme matériau de métallisation,
- la qualité de l'interconnexion électrique obtenue par exemple entre le matériau de métallisation sérigraphié et des parois électriquement conductrices du via est aléatoire.

Le document US 2006 205211 décrit un procédé d'interconnexion entre deux substrats, dans lequel un canal traversant l'un des substrats et aligné avec le via sert d'évent.

### EXPOSÉ DE L'INVENTION

Un but de la présente invention est de proposer une structure d'interconnexion comprenant un ou plusieurs vias borgnes, c'est-à-dire un ou plusieurs vias traversant au moins un premier substrat de la structure d'interconnexion et dont la ou les parois de fond sont formées par au moins un second substrat solidarisé au premier substrat, pouvant être métallisés par des techniques classiques de métallisation tout en s'affranchissant des défauts de métallisation rencontrés dans l'art antérieur, à savoir l'emprisonnement de bulles d'air dans les vias, sous le matériau de métallisation, et/ou le remplissage partiel des vias par le matériau de métallisation.

Pour cela, la présente invention propose une structure d'interconnexion comportant :
- au moins un premier substrat dont au moins une première face est solidarisée à au moins une face d'au moins un second substrat,
- au moins un via borgne traversant le premier substrat et débouchant au niveau de la première face du premier substrat et d'une seconde face, opposée à la première face, du premier substrat,
- au moins un contact électrique disposé contre ladite face du second substrat et en regard du via borgne, et/ou contre la première face et/ou contre la seconde face du premier substrat,
- au moins un canal faisant communiquer le via borgne avec un environnement extérieur à la structure d'interconnexion et/ou avec au moins une cavité formée dans la structure d'interconnexion.

Au moins une partie du canal s'étend de manière sensiblement parallèle à au moins l'une desdites faces du premier et/ou du second substrat, c'est-à-dire parallèle à la première face et/ou à la seconde face du premier substrat, et/ou parallèle à ladite face du second substrat.

Selon l'invention, le via borgne à métalliser de la structure d'interconnexion comporte une ouverture du côté de la seconde face du premier substrat permettant d'introduire dans le via un matériau de métallisation. Le canal débouche dans le via borgne, permettant à l'air, ou plus généralement à un fluide, de circuler entre le via borgne et l'environnement extérieur et/ou une cavité. Ainsi, lorsque le matériau de métallisation est introduit dans le via borgne, l'air ou le fluide présent sous le matériau de métallisation peut donc soit s'échapper à l'extérieur de la structure d'interconnexion lorsque le canal communique avec l'environnement extérieur à la structure, soit s'échapper et être stocké dans une cavité formée dans la structure d'interconnexion, par l'intermédiaire du canal.

Ainsi, aucune bulle d'air ne se trouve emprisonnée dans le via borgne, entre le matériau de métallisation et le second substrat qui forme la paroi de fond du via borgne.

Au moins une partie du canal s'étend de manière horizontale entre le premier substrat et le second substrat, occupant un espace dédié entre ces deux substrats. Cet espace peut être formé par une partie « creusée » en surface de l'un et/ou l'autre des deux substrats, et/ou être formée dans l'épaisseur réservée à une interface de scellement entre les deux substrats. Par rapport à un canal d'évacuation qui traverserait le second substrat dans toute son épaisseur, il est possible de contacter électriquement la face avant (seconde face) et/ou la face arrière (première face) du premier substrat avec la face avant du second substrat. De plus, du fait que le via débouche sur une paroi de fond « pleine » formée d'un matériau (matériau du contact électrique ou du second substrat), c'est-à-dire non percée, il n'est pas nécessaire d'appliquer une couche de mouillabilité pour remplir le via par exemple par un matériau électriquement conducteur. Enfin, la structure de l'invention permet de remplir le via (par exemple par un matériau électriquement conducteur) lorsque le premier substrat est déjà aminci.

La structure d'interconnexion comporte de préférence une pluralité de vias borgnes similaires à celui décrit ci-dessus, c'est-à-dire traversant le premier substrat et dans lesquels débouchent un ou plusieurs canaux permettant à l'air ou à un fluide de s'échapper des vias lors de leur métallisation.

On entend par substrat (aussi bien pour le premier substrat que le second substrat), une structure homogène (c'est-à-dire comportant une seule couche) ou une structure hétérogène (c'est-à-dire comportant un ensemble de couches). Dans le cas où le premier et/ou le second substrat sont hétérogènes, le canal et/ou la cavité peuvent être formés dans au moins une couche du premier substrat et/ou au moins une couche du second substrat et/ou entre une couche du premier substrat et une couche du second substrat, par exemple dans une couche de scellement du premier substrat au second substrat. Le premier et/ou le second substrat peuvent être des puces, des wafers ou tout autre type de structure.

Le premier et le second substrat de la structure d'interconnexion peuvent être deux couches distinctes solidarisées l'une avec l'autre par n'importe quelle technique de scellement et/ou de collage. De plus, il est possible qu'après leur solidarisation, ces deux substrats forment une seule structure ne permettant pas de différencier les deux substrats (par exemple dans le cas d'un collage moléculaire entre les deux substrats qui sont dans ce cas à base d'un même matériau), qui peuvent être assimilés à un seul substrat.

Ainsi, il est également proposé une structure d'interconnexion conformément à la revendication 1. Lorsque le contact électrique est disposé contre la première face et/ou contre la seconde face du premier substrat, ledit contact électrique peut être disposé en périphérie du via borgne.

Le canal et/ou la cavité peuvent être formés dans le premier substrat et/ou dans le second substrat et/ou entre le premier substrat et le second substrat. Lorsque le canal et/ou la cavité sont formés dans le premier substrat et/ou dans le second substrat, des parties évidées, par exemple gravées, du premier substrat et/ou du second substrat, au niveau de la première face du premier substrat et/ou au niveau de ladite face du second substrat (celle en regard de la première face du premier substrat) peuvent former le canal et/ou la cavité.

Le premier substrat peut être solidarisé au second substrat par l'intermédiaire d'une interface de scellement, par exemple à base de colle ou d'une résine de scellement, distincte du premier substrat et du second substrat. Ainsi, il est possible de réaliser le canal et/ou la cavité dans l'interface de scellement, entre le premier substrat et le second substrat.

Dans ce cas, le canal peut être formé par au moins un espace séparant au moins deux portions de l'interface de scellement.

L'interface de scellement peut comporter une pluralité de portions disjointes de matériau disposées sensiblement en périphérie du via borgne.

La structure d'interconnexion peut comporter en outre au moins un second via borgne traversant le premier substrat et débouchant au niveau de la première face et de la seconde face du premier substrat, le canal pouvant faire communiquer ledit via borgne avec l'environnement extérieur par l'intermédiaire du second via borgne.

Dans ce cas, lorsque le premier substrat est solidarisé au second substrat par l'intermédiaire d'une interface de scellement distincte du premier substrat et du second substrat, ledit canal peut être formé par au moins un espace séparant une première portion de l'interface de scellement d'une seconde portion de l'interface de scellement dont le motif est inclus, ou imbriqué, dans une zone définie par un motif de la première portion de l'interface de scellement. Dans une telle configuration, la première portion de l'interface de scellement peut former des chemins de découpe de la structure d'interconnexion et la seconde portion de l'interface de scellement peut former un renfort mécanique d'un circuit électronique réalisé dans la structure d'interconnexion.

La cavité peut être formée par au moins un espace séparant une première portion de l'interface de scellement d'une seconde portion de l'interface de scellement dont le motif est inclus, ou imbriqué, dans une zone définie par un motif de la première portion de l'interface de scellement.

La structure d'interconnexion peut comporter en outre une pluralité de vias borgnes traversant le premier substrat et débouchant au niveau de la première face et de la seconde face du premier substrat, le canal pouvant faire communiquer les vias borgnes les uns avec les autres.

L'invention concerne également un procédé de réalisation d'une structure d'interconnexion, conformément à la revendication 11 et comportant au moins les étapes de :
- réalisation d'au moins un via traversant au moins un premier substrat et débouchant au niveau d'une première face du premier substrat et d'une seconde face, opposée à la première face, du premier substrat,
- réalisation d'au moins un contact électrique contre une face d'un second substrat et destiné à être disposé en regard du via, et/ou contre la première face et/ou contre la seconde face du premier substrat,
- réalisation d'au moins un canal destiné à faire communiquer le via avec un environnement extérieur à la structure d'interconnexion et/ou avec au moins une cavité formée dans la structure d'interconnexion,
- solidarisation de la première face du premier substrat à ladite face du second substrat.

Au moins une partie du canal s'étend de manière sensiblement parallèle à au moins l'une desdites faces du premier et/ou du second substrat, c'est-à-dire parallèle à la première face et/ou à la seconde face du premier substrat, et/ou parallèle à ladite face (celle en regard de la première face du premier substrat) du second substrat.

L'étape de solidarisation peut comporter un report ou un transfert d'un des substrats sur l'autre avec un maintien desdits substrats entre eux.

Le canal et/ou la cavité peuvent être réalisés dans le premier substrat et/ou dans le second substrat et/ou entre le premier substrat et le second substrat.

Le premier substrat peut être solidarisé au second substrat par l'intermédiaire d'au moins une interface de scellement distincte du premier substrat et du second substrat.

La réalisation du canal peut être obtenue au moins par la mise en oeuvre des étapes suivantes :
- dépôt d'une couche à base de résine de scellement sur la première face du premier substrat et/ou sur ladite face du second substrat ;
- insolation de la couche à base de résine de scellement par l'intermédiaire d'un masque comprenant au moins un motif correspondant à celui du canal à réaliser ;
- développement de la couche à base de résine de scellement, formant, ou pour former, l'interface de scellement et le canal.

Dans une variante, la réalisation du canal peut être obtenue au moins par la mise en oeuvre d'un dépôt d'une couche de colle sur la première face du premier substrat et/ou sur ladite face du second substrat, la couche de colle étant structurée de façon à avoir au moins un motif correspondant à l'interface de scellement et au canal à réaliser.

La réalisation du canal peut être obtenue au moins par une étape de gravure du premier et/ou du second substrat.

L'invention concerne également un procédé de métallisation d'au moins un via borgne d'une structure d'interconnexion telle que définie précédemment, comportant au moins une étape de remplissage du via borgne par au moins un matériau électriquement conducteur.

Le remplissage du via borgne peut comporter la mise en oeuvre d'une étape de sérigraphie du matériau électriquement conducteur sur la structure d'interconnexion.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1C et 2A à 2D représentent partiellement une structure d'interconnexion, objet de la présente invention, selon différentes variantes d'un premier mode de réalisation,
- les figures 3 à 5 représentent des vues partielles en coupe d'une structure d'interconnexion, objet de la présente invention, selon un second, troisième et quatrième mode de réalisation,
- les figures 6A à 6D représentent des étapes d'un procédé de réalisation de la structure d'interconnexion, objet de la présente invention, selon le premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

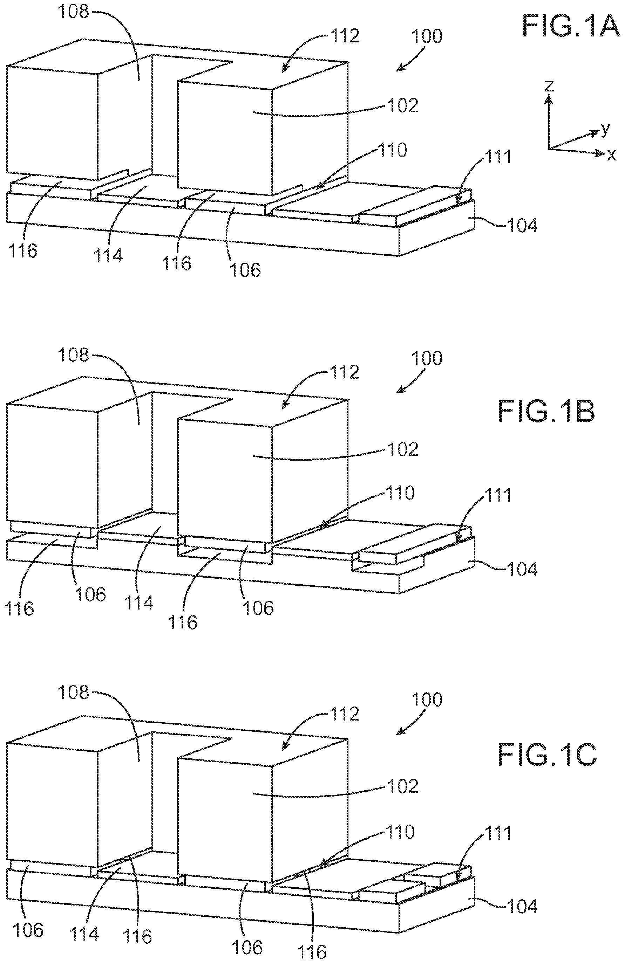

On se réfère tout d'abord aux figures 1A à 1C qui représentent partiellement une structure d'interconnexion 100 selon différentes variantes d'un premier mode de réalisation.

La structure d'interconnexion 100 comporte un premier substrat 102 solidarisé à un second substrat 104 par l'intermédiaire d'une interface de scellement 106. Les premier et second substrats 102 et 104 sont par exemple à base de silicium et ont chacun une épaisseur (dimension selon l'axe représenté sur la figure 1A) égale à environ 720 µm. L'interface de scellement 106 est par exemple à base de colle ou de résine et a par exemple une épaisseur comprise entre environ 3 µm et 20 µm.

La structure d'interconnexion 100 comporte un via borgne 108 réalisé à travers le premier substrat 102. Le via borgne 108 est traversant dans le premier substrat 102, c'est-à-dire comporte une ouverture au niveau d'une première face 110 (qui est en contact avec l'interface de scellement 106) du premier substrat 102 et au niveau d'une seconde face 112, opposée à la première face 110, du premier substrat 102. Le via borgne 108 débouche donc sur une face 111 du second substrat 104 sur laquelle est réalisée un contact électrique 114, par exemple à base d'un matériau électriquement conducteur tel que du métal (par exemple de l'or), qui forme une paroi de fond du via borgne 108, ce contact électrique 114 se trouvant en regard de l'espace vide formé par le via borgne 108 dans le premier substrat 102.

Sur les exemples des figures 1A à 1C, le via borgne 108 a une section, dans le plan (X,Y) qui est parallèle aux faces 110 et 112 du premier substrat 102 au niveau desquelles le via borgne 108 est débouchant, de forme carrée dont un côté a par exemple une dimension égale à environ 100 µm. Le via borgne 108 peut toutefois être réalisé selon une forme différente, par exemple cylindrique et dont la section dans un plan parallèle au plan (X,Y) comporte un diamètre par exemple égal à environ 100 µm.

Bien que non représentés, des dispositifs microélectroniques (transistors, capteurs CMOS, etc.) sont réalisés sur le premier substrat 102 et/ou le second substrat 104 et au moins de ces dispositifs est relié électriquement au contact électrique 114.

La structure d'interconnexion 100 comporte en outre un canal 116 permettant de faire communiquer le volume intérieur du via borgne 108 avec l'environnement extérieur à la structure d'interconnexion 100 ou une cavité formée dans la structure d'interconnexion 100.

Sur l'exemple de la figure 1A, deux canaux 116 sont formés dans le premier substrat 102, au niveau de sa première face 110. Ces canaux 116 forment des espaces vides gravés dans le premier substrat 102, au niveau de la première face 110. Les canaux 116 s'étendent donc horizontalement entre le premier substrat 102 et le second substrat 104. Du fait que les canaux 116 sont formés par des parties « évidées » en surface du premier substrat, ces canaux 116 s'étendent notamment entre le premier substrat 102 et une partie de l'interface de scellement 106.

Ainsi, lorsqu'un matériau de métallisation est introduit dans le via borgne 108, par exemple par l'intermédiaire d'une racle de sérigraphie, le matériau de métallisation s'écoule dans le via borgne 108 et l'air présent dans l'espace vide du via borgne 108, sous le matériau de métallisation, peut s'échapper par ces canaux 116 pour être évacué soit vers l'extérieur de la structure d'interconnexion, soit vers une cavité dans laquelle l'air est destiné à être stocké.

Dans la variante de réalisation représentée sur la figure 1B, les deux canaux 116 sont formés dans le second substrat 104, au niveau de la face 111 qui est en contact avec l'interface de scellement 106. Ces canaux 116 forment des espaces vides gravés dans le second substrat 104, formant des canaux de circulation d'air jouant un rôle similaire à celui décrit ci-dessus pour les canaux 116 de la variante représentée sur la figure 1A. Les canaux 116 s'étendent donc horizontalement entre le premier substrat 102 et le second substrat 104, et plus précisément ici entre le second substrat 104 et une partie de l'interface de scellement 106. Une partie des canaux 116 en forme de chicane fait communiquer la partie horizontale des canaux avec le via 108.

Dans la variante de réalisation représentée sur la figure 1C, les deux canaux 116 sont formés entre le premier substrat 102 et le second substrat 104, c'est-à-dire dans l'interface de scellement 106. Ainsi, ces canaux 116 forment des espaces vides entre des portions distinctes de l'interface de scellement 106 permettant de faire communiquer l'intérieur du via borgne 108 avec l'environnement extérieur et/ou une cavité formée dans la structure d'interconnexion 100. Une telle variante a notamment pour avantage de ne pas nécessiter la mise en oeuvre d'étape de gravure d'un ou des substrats 102 et 104. Là encore, les canaux 116 s'étendent horizontalement entre le premier substrat 102 et le second substrat 104.

Les largeurs des canaux 116 peuvent être par exemple comprises entre quelques micromètres et quelques centaines de micromètres. Les dimensions des canaux peuvent être choisies en fonction par exemple de la viscosité du matériau destiné à remplir les vias borgnes, par exemple pour que ce matériau de métallisation ne s'écoule pas dans les canaux.

Il est possible de combiner les variantes de réalisation précédemment décrites. Ainsi, les canaux 116 peuvent être réalisés dans le premier substrat 102 et/ou dans le second substrat 104 et/ou dans l'interface de scellement 106.

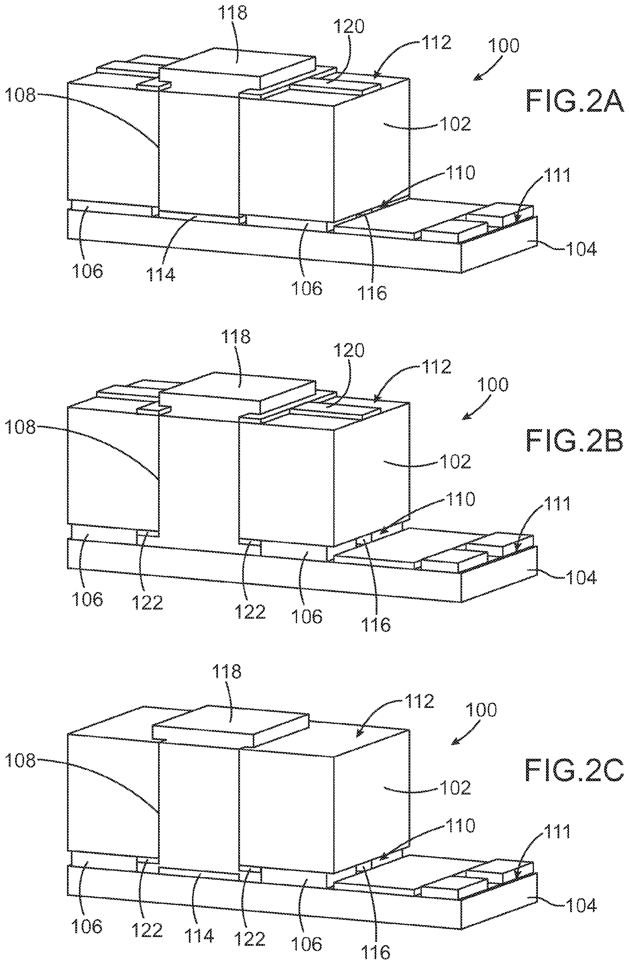

Les figures 2A à 2D représentent partiellement la structure d'interconnexion 100 selon différentes variantes du premier mode de réalisation.

Sur ces figures 2A à 2D, le via borgne 108 de la structure d'interconnexion 100 est rempli par un matériau de métallisation 118 permettant de former une interconnexion électrique entre au moins deux contacts électriques réalisés sur le premier substrat 102 et/ou sur le second substrat 104, et/ou de réaliser une reprise d'un contact électrique réalisé sur le premier substrat 102 et/ou sur le second substrat 104.

Sur l'exemple de la figure 2A, la métallisation 118 relie électriquement un premier contact électrique 114, similaire au contact électrique 114 représenté sur les figures 1A à 1C, à un second contact électrique 120 réalisé sur la seconde face 112 du premier substrat 102, en périphérie du via borgne 108. Le matériau de la métallisation 118 peut recouvrir le second contact électrique 120, augmentant ainsi la surface de contact électrique au niveau de seconde face 112, ce qui permet de réduire la résistance électrique de ce contact.

Sur l'exemple de la figure 2B, la structure d'interconnexion 100 ne comporte pas le premier contact électrique 114, la métallisation 118 reliant électriquement le second contact électrique 120 à un troisième contact électrique 122 réalisé contre la première face 110 du premier substrat 102, en périphérie du via borgne 108.

Sur l'exemple de la figure 2C, la structure d'interconnexion 100 ne comporte pas le second contact électrique 120, la métallisation 118 reliant électriquement le premier contact électrique 114 au troisième contact électrique 122. Dans cette variante, la métallisation 118 forme donc un accès électrique aux contacts 114 et 122 depuis la seconde face 112 du premier substrat 102.

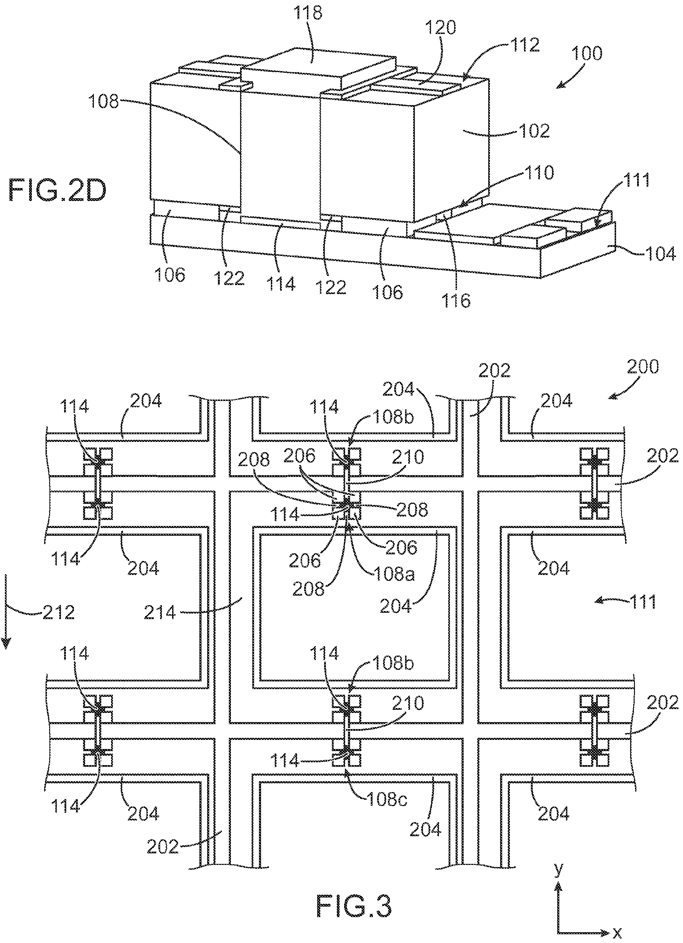

Enfin, sur l'exemple de la figure 2D, la métallisation 118 relie électriquement les premier, second et troisième contacts électriques 114, 120 et 122 ensembles.

Dans les variantes représentées sur les figures 2A à 2D, la métallisation 118 relie électriquement au moins deux contacts électriques formés au niveau du via borgne 108. Toutefois, il est possible qu'un seul des contacts électriques 114, 120 ou 122 soit réalisé au niveau du via borgne 108. Dans ce cas, la métallisation 118 forme un accès électrique à ce contact depuis l'une des faces de la structure d'interconnexion 100.

Ainsi, dans les exemples décrits en liaison avec les précédentes figures 1A à 1C et 2A à 2D, le via borgne 108 est destiné à recevoir un matériau de métallisation permettant de former une connexion électrique avec au moins un contact électrique formé sur le premier substrat 102 et/ou au moins un contact électrique formé sur le second substrat 104. La position horizontale des canaux 116 permet notamment de ne pas avoir d'écoulement du matériau de métallisation 118 dans les canaux 116.

On se réfère maintenant à la figure 3 qui représente partiellement une vue en coupe d'une structure d'interconnexion 200 selon un deuxième mode de réalisation.

La structure d'interconnexion 200 est réalisée selon la même variante que la structure d'interconnexion 100 représentée sur la figure 1C.

Ainsi, la structure d'interconnexion 200 comporte le premier substrat 102 solidarisé au second substrat 104 par l'intermédiaire de l'interface de scellement 106. Des vias borgnes 108 sont réalisés à travers le premier substrat 102 et débouchent dans des canaux 116 formés dans l'interface de scellement 106.

La vue représentée sur la figure 3 correspond à une vue en coupe réalisée dans le plan de l'interface de scellement 106 qui est parallèle au plan (X,Y). Ainsi, la face 111 du second substrat 104, l'interface de scellement 106 et les contacts électriques 114 sont notamment représentés sur la figure 3.

La structure d'interconnexion 200 comporte une pluralité de circuits électroniques, non représentés sur la figure 3, réalisés par exemple sur le premier substrat 102. L'interface de scellement 106 permet de réaliser la liaison mécanique entre le premier substrat 102 et le second substrat 104.

De plus, le motif particulier de l'interface de scellement 106 représentée sur la figure 3 lui permet de remplir d'autres fonctions.

Ainsi, des premières portions 202 de l'interface de scellement 106 réalisées sous la forme de bandes continues se croisant perpendiculairement forment un quadrillage dont les carrés délimitent les emplacements des différents circuits électroniques de la structure d'interconnexion 200. Ce quadrillage forme des chemins de découpe, ou chemins de clivage, pour la découpe individuelle des circuits électroniques réalisés dans la structure d'interconnexion 200 et permettent, lorsque les substrats 102 et 104 sont découpés, d'éviter d'endommager les zones des substrats sur lesquelles les circuits électroniques sont réalisés. Des secondes portions 204 de l'interface de scellement 106 forment des motifs rectangulaires délimitant les parties actives des circuits électroniques, ces secondes portions 204 étant incluses dans les motifs carrés formés par les premières portions 202 de l'interface de scellement 106. Ces secondes portions 204 servent également de renforts mécaniques pour les parties actives des circuits électroniques.

Sur l'exemple de réalisation représenté sur la figure 3, chaque contact électrique 114 est entouré par une pluralité de portions 206 de matériau de l'interface de scellement 106. Ces portions 206 sont ici de forme carré et espacées les unes des autres afin que des espaces 208 soient présents entre ces portions 206. Ainsi, étant donné que les vias borgnes 108 sont réalisés à travers le premier substrat et en regard des contacts électriques 114, chacun des espaces 208 forme une partie d'un canal de circulation d'air entre le via borgne 108 se trouvant à l'aplomb d'un des contacts électriques 114 et un espace 214 formé entre un des motifs formés par le quadrillage des premières portions 202 et une des secondes portions 204 de l'interface de scellement 106. Des espaces 210 sont également réalisés à travers les première portions 202 qui sont parallèle à l'axe X afin de faire communiquer les vias borgnes 108 réalisés de part et d'autre d'une bande faisant partie des première portions 202 de l'interface de scellement 106.

On décrit maintenant le déroulement de la métallisation de vias borgnes 108a, 108b et 108c de la structure d'interconnexion 200. Cette métallisation est ici réalisée par sérigraphie. Ainsi, le matériau de métallisation est étalé par une racle de sérigraphie dans le sens de la flèche 212 représentée sur la figure 3.

Le matériau de métallisation est tout d'abord introduit dans le via borgne 108a. L'air présent dans le via borgne 108a est alors évacué en passant tout d'abord par les espaces 208 formés entre les portions 206 se trouvant en périphérie de ce via, puis dans l'espace 214 formé entre les premières portions 202 et l'une des secondes portions 204 de l'interface de scellement 106. L'air passe ensuite par les espaces 208 formés entre les portions 206 se trouvant en périphérie du via borgne 108b, puis est évacué vers l'extérieur par le via borgne 108b.

Lorsque la racle de sérigraphie arrive au niveau du via borgne 108b, le matériau de métallisation est introduit dans le via borgne 108b. L'air présent dans le via borgne 108b est ensuite évacué à l'extérieur par le via borgne 108c, l'air passant du via 108b au via 108c par l'intermédiaire de l'espace 210 mettant en communication les vias 108b et 108c.

Le procédé de métallisation décrit ci-dessus pour les trois vias borgnes 108a à 108c s'applique simultanément à tous les vias formés dans la structure d'interconnexion 200 se trouvant sur un même axe parallèle à l'axe X. Ainsi, les canaux de circulation d'air formés dans la structure d'interconnexion 200 permettent à la pression générée lorsque le matériau de métallisation est introduit dans les vias borgnes de s'équilibrer avec les vias borgnes disposés en aval dans le sens de la sérigraphie.

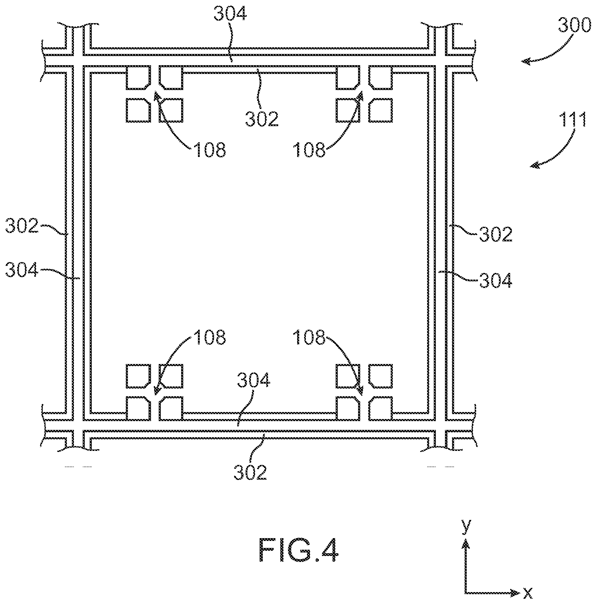

On se réfère maintenant à la figure 4 qui représente partiellement une vue en coupe d'une structure d'interconnexion 300 selon un troisième mode de réalisation.

Par rapport à la structure d'interconnexion 200 précédemment décrite, des portions 302 de l'interface de scellement 106 forment des canaux 304 s'étendant sur toute la longueur et toute la largeur des substrats 102 et 104. Chacun des vias borgnes 108 est en communication avec l'un de ces canaux 304 par lesquels, lorsque du matériau de métallisation est introduit dans les vias borgnes 108, l'air peut s'échapper. A l'extrémité de ces canaux 304, il est possible de prévoir des vias borgnes, ne comportant pas nécessairement de contact électrique, qui seront également bouchés par le matériau de métallisation et qui serviront à fermer la circulation d'air entre les canaux 304 et l'environnement extérieur à la structure d'interconnexion 300. Sur l'exemple de la figure 4, les vias borgnes 108 communiquent avec les canaux 304, mais également avec l'intérieur du motif délimité par la portion 302 de forme rectangulaire, et donc communiquent également entre eux. Dans une variante, il est possible que les vias borgnes 108 ne communiquent pas avec l'intérieur du motif délimité par la portion 302 de forme rectangulaire, mais ne communiquent qu'avec les canaux 304, l'évacuation de l'air ne s'opérant dans ce cas que par les chemins de découpe.

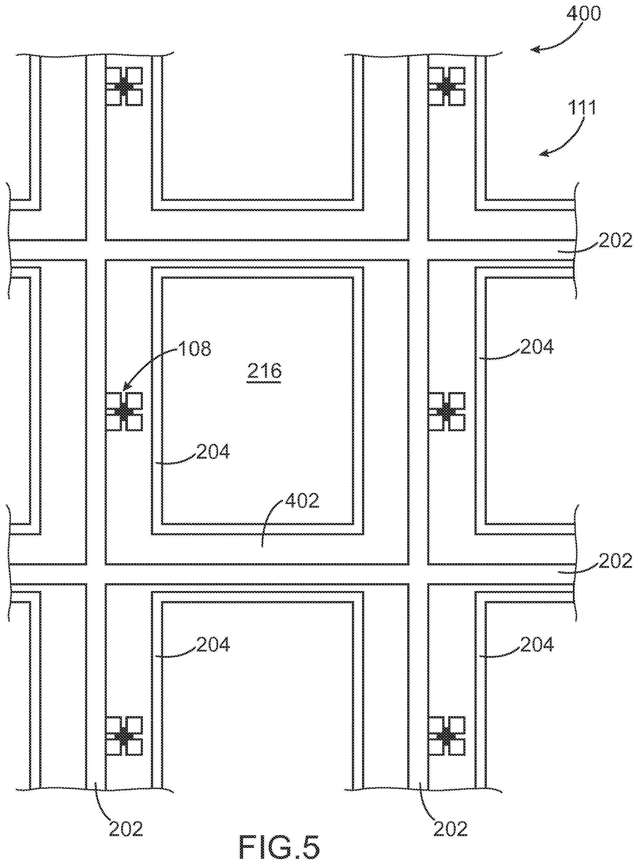

On se réfère maintenant à la figure 5 qui représente partiellement une vue en coupe d'une structure d'interconnexion 400 selon un quatrième mode de réalisation.

De manière analogue à la structure d'interconnexion 200 précédemment décrite, les premières portions 202 de l'interface de scellement 106 forment un quadrillage dans lequel sont disposées des secondes portions 204 de l'interface de scellement 106 comportant par exemple des motifs rectangulaires délimitant la partie active des circuits électroniques de la structure d'interconnexion 400.

Contrairement à la structure d'interconnexion 200, un seul via borgne 108 est en communication avec l'espace 402 formé entre l'une des secondes portions 204 de l'interface de scellement 106 et un carré formé par le quadrillage des premières portions 202 de l'interface de scellement 106. Ainsi, cet espace 402 forme une cavité dans laquelle, lorsque le matériau de métallisation est introduit dans le via borgne 108, l'air est emprisonné. Dans cette configuration, on tient compte du volume de la cavité 402, de la compressibilité du fluide se trouvant dans les vias borgnes 108 avant la sérigraphie (par exemple le type de gaz ou l'air) et des propriétés rhéologiques du matériau de métallisation afin d'obtenir un remplissage optimal des vias borgnes 108 par le matériau de métallisation.

Dans une variante de réalisation de la structure d'interconnexion 400, il est possible que les secondes portions 204 de l'interface de scellement 106 ne forment pas un motif à contour fermé, mais qu'une ouverture soit réalisée dans le motif des secondes portions 204 de l'interface de scellement 106. Ainsi, l'espace 216 se trouvant à l'intérieur de la seconde portion 214 de l'interface de scellement communique avec l'espace 402, augmentant ainsi le volume total de la cavité dans laquelle l'air ou le fluide provenant du via borgne 108 est emprisonné.

Dans une autre variante, il est également possible que les chemins de découpes 202 comportent des ouvertures afin de faire communiquer les différentes cavités 402 les unes avec les autres, l'air pouvant ainsi s'échapper, lors d'une sérigraphie, par les vias borgnes 108 disposés en aval des vias borgnes se remplissant de matériau de métallisation, dans le sens de la sérigraphie.

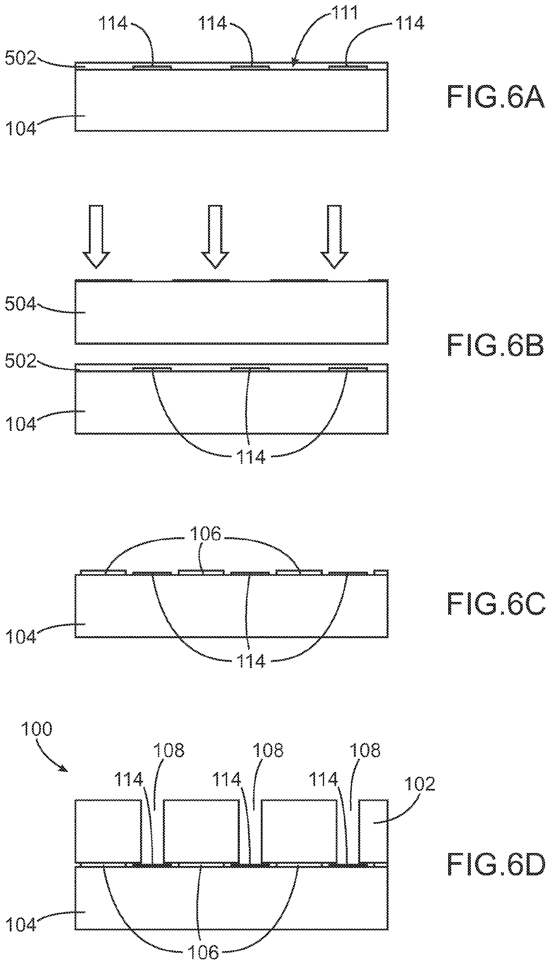

On se réfère maintenant aux figures 6A à 6D qui représentent les étapes d'un procédé de réalisation de la structure d'interconnexion 100, ici réalisée selon la variante représentée sur la figure 1C, c'est-à-dire dont les canaux sont réalisés dans l'interface de scellement 106.

Comme représenté sur la figure 6A, le second substrat 104, qui comporte les contacts électriques 114 réalisés sur sa face 111, est recouvert d'une couche 502 à base de résine de scellement.

Cette couche 502, par exemple déposée par la mise en oeuvre d'un dépôt à la tournette, recouvre également les contacts électriques 114.

On réalise ensuite une insolation de la couche 502 par l'intermédiaire d'un masque de lithographie 504 dont le motif correspond à celui de l'interface de scellement 106 destinée à être réalisée (figure 6B). Ce motif inclut également les canaux et éventuellement les cavités destinés à être réalisés dans l'interface de scellement 106. La couche insolée 502 est ensuite développée, par exemple par une solution de gravure adaptée à la résine de la couche 502, formant ainsi l'interface de scellement 106.

Enfin, le premier substrat 102 dans lequel les vias borgnes 108 sont préalablement réalisés, est reporté et scellé au second substrat 104, formant la structure d'interconnexion 100. Les vias borgnes 108 sont ainsi prêts à être métallisé, par exemple par la mise en oeuvre d'une sérigraphie ou tout autre procédé de métallisation adapté, les canaux de circulation d'air réalisés dans l'interface de scellement 106 permettant l'évacuation de l'air, initialement présent dans les vias borgnes 108, vers l'extérieur ou le stockage de l'air dans une cavité.

Dans une variante de réalisation, il est possible de réaliser l'interface de scellement 106 en déposant une couche de colle sur la première face du premier substrat 102 et/ou sur la face 111 du second substrat 104. La couche de colle est structurée de façon à avoir au moins un motif correspondant à l'interface de scellement et au canal à réaliser.

## Revendications

1. Structure (100, 200, 300, 400) destinée à la réalisation d'au moins une interconnexion avec au moins un contact électrique (114, 120, 122), comportant :
- au moins un premier substrat (102) dont au moins une première face (110) est solidarisée à au moins une face (111) d'au moins un second substrat (104),
- au moins un via borgne (108) traversant le premier substrat (102) et débouchant au niveau de la première face (110) du premier substrat (102) et d'une seconde face (112), opposée à la première face (110), du premier substrat (102),
- le contact électrique (114, 120, 122) disposé contre ladite face (111) du second substrat (104) et en regard du via borgne (108), et/ou contre la première face (110) et/ou contre la seconde face (112) du premier substrat (102),
- au moins un canal (116, 208, 214, 304) faisant communiquer un volume intérieur du via borgne (108) avec un environnement extérieur à la structure (100, 200, 300, 400) et/ou avec au moins une cavité (402) formée dans la structure (100, 200, 300, 400), adapté pour réaliser une circulation d'air ou d'un fluide présent dans le volume intérieur du via (108) par ce canal (116, 208, 214, 304), et dont au moins une partie s'étend de manière sensiblement parallèle à au moins l'une desdites faces (110, 111, 112) du premier (102) et/ou du second substrat (104).

2. Structure (100, 200, 300, 400) selon la revendication 1, dans lequel, lorsque le contact électrique (120, 122) est disposé contre la première face (110) et/ou contre la seconde face (112) du premier substrat (102), ledit contact électrique (120, 122) est disposé en périphérie du via borgne (108).

3. Structure (100, 200, 300, 400) selon l'une des revendications précédentes, dans laquelle le canal (116, 208, 214, 304) et/ou la cavité (402) sont formés dans le premier substrat (102) et/ou dans le second substrat (104) et/ou entre le premier substrat (102) et le second substrat (104).

4. Structure (100, 200, 300, 400) selon l'une des revendications précédentes, dans laquelle le premier substrat (102) est solidarisé au second substrat (104) par l'intermédiaire d'au moins une interface de scellement (106) distincte du premier substrat (102) et du second substrat (104).

5. Structure (100, 200, 300, 400) selon la revendication 4, dans laquelle le canal (116, 208, 214, 304) est formé par au moins un espace séparant au moins deux portions (202, 204, 206, 302) de l'interface de scellement (106).

6. Structure (200, 300, 400) selon l'une des revendications 4 ou 5, dans laquelle l'interface de scellement (106) comporte une pluralité de portions (206) disjointes de matériau disposées sensiblement en périphérie du via borgne (108).

7. Structure (200, 300) selon l'une des revendications précédentes, comportant en outre au moins un second via borgne (108) traversant le premier substrat (102) et débouchant au niveau de la première face (110) et de la seconde face (112) du premier substrat (102), le canal (208, 214, 304) faisant communiquer ledit volume intérieur du via borgne (108) avec l'environnement extérieur (200, 300) par l'intermédiaire du second via borgne (108).

8. Structure (200) selon la revendication 7, dans lequel, lorsque le premier substrat (102) est solidarisé au second substrat (104) par l'intermédiaire d'une interface de scellement (106) distincte du premier substrat (102) et du second substrat (104), le canal (208, 214) est formé par au moins un espace (214) séparant une première portion (202) de l'interface de scellement (106) d'une seconde portion (204) de l'interface de scellement (106) dont le motif est inclus dans une zone définie par un motif de la première portion (202) de l'interface de scellement (106).

9. Structure (400) selon l'une des revendications 1 à 6, dans lequel la cavité (402) est formée par au moins un espace (402) séparant une première portion (202) de l'interface de scellement (106) d'une seconde portion (204) de l'interface de scellement (106) dont le motif est inclus dans une zone définie par un motif de la première portion (202) de l'interface de scellement (106).

10. Structure (300) selon l'une des revendications 1 à 7, comportant en outre une pluralité de vias borgnes (108) traversant le premier substrat (102) et débouchant au niveau de la première face (110) et de la seconde face (112) du premier substrat (102), le canal (304) faisant communiquer des volumes intérieurs des vias borgnes (108) les uns avec les autres.

11. Procédé de réalisation d'une structure (100, 200, 300, 400) destinée à la réalisation d'au moins une interconnexion avec au moins un contact électrique (114, 120, 122), comportant au moins les étapes de :
- réalisation d'au moins un via (108) traversant au moins un premier substrat (102) et débouchant au niveau d'une première face (110) du premier substrat (102) et d'une seconde face (112), opposée à la première face (110), du premier substrat (102),
- réalisation d'au moins un contact électrique (114, 120, 122) contre une face (111) d'un second substrat (104) et destiné à être disposé en regard du via (108), et/ou contre la première face (110) et/ou contre la seconde face (112) du premier substrat (102),
- réalisation d'au moins un canal (116, 208, 214, 304) destiné à faire communiquer un volume intérieur du via (108) avec un environnement extérieur à la structure d'interconnexion (100, 200, 300, 400) et/ou avec au moins une cavité (402) formée dans la structure d'interconnexion (100, 200, 300, 400), adapté pour réaliser une circulation d'air ou d'un fluide présent dans le volume intérieur du via (108) par ce canal (116, 208, 214, 304), et dont au moins une partie s'étend de manière sensiblement parallèle à au moins l'une desdites faces (110, 111, 112) du premier (102) et/ou du second substrat (104),
- solidarisation de la première face (110) du premier substrat (102) à ladite face (111) du second substrat (104).

12. Procédé de réalisation selon la revendication 11, dans lequel le canal (116, 208, 214, 304) et/ou la cavité (402) sont réalisés dans le premier substrat (102) et/ou dans le second substrat (104) et/ou entre le premier substrat (102) et le second substrat (104).

13. Procédé de réalisation selon l'une des revendications 11 ou 12, dans lequel le premier substrat (102) est solidarisé au second substrat (104) par l'intermédiaire d'au moins une interface de scellement (106) distincte du premier substrat (102) et du second substrat (104).

14. Procédé de réalisation selon la revendication 13, dans lequel la réalisation du canal (116, 208, 214, 304) est obtenue au moins par la mise en oeuvre des étapes suivantes :
- dépôt d'une couche (502) à base de résine de scellement sur la première face (110) du premier substrat (102) et/ou sur ladite face (111) du second substrat (104),
- insolation de la couche (502) à base de résine de scellement par l'intermédiaire d'un masque (504) comprenant au moins un motif correspondant à celui du canal (116, 208, 214, 304) à réaliser,
- développement de la couche (502) à base de résine de scellement, formant l'interface de scellement (106) et le canal (116, 208, 214, 304).

15. Procédé de réalisation selon la revendication 13, dans lequel la réalisation du canal (116, 208, 214, 304) est obtenue au moins par la mise en oeuvre d'un dépôt d'une couche de colle sur la première face (110) du premier substrat (102) et/ou sur ladite face (111) du second substrat (104), la couche de colle étant structurée de façon à avoir au moins un motif correspondant à l'interface de scellement (106) et au canal (116, 208, 214, 304) à réaliser.

16. Procédé de métallisation d'au moins un via borgne (108) d'une structure (100, 200, 300, 400) selon l'une des revendications 1 à 10, comportant au moins une étape de remplissage du via borgne (108) par au moins un matériau électriquement conducteur.

17. Procédé de métallisation selon la revendication 16, dans lequel le remplissage du via borgne (108) comporte la mise en oeuvre d'une étape de sérigraphie du matériau électriquement conducteur sur la structure (100, 200, 300, 400).

## Patentansprüche

1. Struktur (100, 200, 300, 400), die zur Herstellen zumindest einer Verbindung mit zumindest einem elektrischen Kontaktstück (114, 120, 122) bestimmt ist, enthaltend:
- zumindest ein erstes Substrat (102), von dem zumindest eine erste Fläche (110) fest mit zumindest einer Fläche (111) zumindest eines zweiten Substrats (104) verbunden ist,
- zumindest ein Sackloch (108), das das erste Substrat (102) durchsetzt und im Bereich der ersten Fläche (110) des ersten Substrats (102) und einer der ersten Fläche (110) entgegengesetzten zweiten Fläche (112) des ersten Substrats (102) ausmündet,
- wobei das elektrische Kontaktstück (114, 120, 122) an der Fläche (111) des zweiten Substrats (104) angeordnet ist und dem Sackloch (108) gegenüberliegt, und/oder an der ersten Fläche (110) und/oder an der zweiten Fläche (112) des ersten Substrats (102),
- zumindest einen Kanal (116, 208, 214, 304), der ein Innenraumvolumen des Sacklochs (108) mit einer Umgebung außerhalb der Struktur (100, 200, 300, 400) und/oder mit zumindest einem in der Struktur (100, 200, 300, 400) ausgebildeten Hohlraum (402) verbindet, dazu ausgelegt ist, eine Strömung von Luft oder Fluid, das in dem Innenraumvolumen des Sacklochs (108) vorhanden ist, über diesen Kanal (116, 208, 214, 304) herzustellen, und von dem zumindest ein Teil sich im Wesentlichen parallel zu zumindest einer der Flächen (110, 111, 112) des ersten (102) und/oder zweiten Substrats (104) erstreckt.

2. Struktur (100, 200, 300, 400) nach Anspruch 1, wobei dann, wenn das elektrische Kontaktstück (120, 122) an der ersten Fläche (110) und/oder an der zweiten Fläche (112) des ersten Substrats (102) angeordnet ist, das elektrische Kontaktstück (120, 122) am Umfang des Sacklochs (108) angeordnet ist.

3. Struktur (100, 200, 300, 400) nach einem der vorangehenden Ansprüche, wobei der Kanal (116, 208, 214, 304) und/oder der Hohlraum (402) in dem ersten Substrat (102) und/oder in dem zweiten Substrat (104) und/oder zwischen dem ersten Substrat (102) und dem zweiten Substrat (104) ausgebildet sind.

4. Struktur (100, 200, 300, 400) nach einem der vorangehenden Ansprüche, wobei das erste Substrat (102) fest mit dem zweiten Substrat (104) über zumindest eine Dichtungsschnittstelle (106) verbunden ist, die separat vom ersten Substrat (102) und vom zweiten Substrat (104) vorliegt.

5. Struktur (100, 200, 300, 400) nach Anspruch 4, wobei der Kanal (116, 208, 214, 304) aus zumindest einem Raum gebildet ist, der zumindest zwei Abschnitte (202, 204, 206, 302) der Dichtungsschnittstelle (106) trennt.

6. Struktur (200, 300, 400) nach einem der Ansprüche 4 oder 5, wobei die Dichtungsschnittstelle (106) eine Mehrzahl von getrennten Materialabschnitten (206) aufweist, die im Wesentlichen am Umfang des Sacklochs (108) angeordnet sind.

7. Struktur (200, 300) nach einem der vorangehenden Ansprüche, ferner enthaltend zumindest ein zweites Sackloch (108), das das erste Substrat (102) durchsetzt und im Bereich der ersten Fläche (110) und der zweiten Fläche (112) des ersten Substrats (102) ausmündet, wobei der Kanal (208, 214, 304) das Innenraumvolumen des Sacklochs (108) über das zweite Sackloch (108) mit der Außenumgebung (200, 300) verbindet.

8. Struktur (200) nach Anspruch 7, wobei dann, wenn das erste Substrat (102) fest mit dem zweiten Substrat (104) über eine Dichtungsschnittstelle (106) verbunden ist, die vom ersten Substrat (102) und vom zweiten Substrat (104) separat vorliegt, der Kanal (208, 214) aus zumindest einem Raum (214) gebildet ist, welcher einen ersten Abschnitt (202) der Dichtungsschnittstelle (106) von einem zweiten Abschnitt (204) der Dichtungsschnittstelle (106) trennt, dessen Gestalt in einem Bereich eingeschlossen ist, der von einer Gestalt des ersten Abschnitts (202) der Dichtungsschnittstelle (106) definiert wird.

9. Struktur (400) nach einem der Ansprüche 1 bis 6, wobei der Hohlraum (402) aus zumindest einem Raum (402) gebildet ist, welcher einen ersten Abschnitt (202) der Dichtungsschnittstelle (106) von einem zweiten Abschnitt (204) der Dichtungsschnittstelle (106) trennt, dessen Gestalt in einem Bereich eingeschlossen ist, der von einer Gestalt des ersten Abschnitts (202) der Dichtungsschnittstelle (106) definiert wird.

10. Struktur (300) nach einem der Ansprüche 1 bis 7, ferner enthaltend eine Mehrzahl von Sacklöchern (108), die das erste Substrat (102) durchsetzten und im Bereich der ersten Fläche (110) und der zweiten Fläche (112) des ersten Substrats (102) ausmünden, wobei der Kanal (304) die Innenraumvolumen der Sacklöcher (108) miteinander verbindet.

11. Verfahren zum Herstellen einer Struktur (100, 200, 300, 400), die zur Herstellung zumindest einer Verbindung mit zumindest einem elektrischen Kontaktstück (114, 120, 122) bestimmt ist, umfassend zumindest die nachfolgenden Schritte:
- Ausbilden zumindest eines Sacklochs (108), das zumindest ein erstes Substrat (102) durchsetzt und im Bereich einer ersten Fläche (110) des ersten Substrats (102) und einer der ersten Fläche (110) entgegengesetzten zweiten Fläche (112) des ersten Substrats (102) ausmündet,
- Herstellen zumindest eines elektrischen Kontaktstücks (114, 120, 122) an einer Fläche (111) eines zweiten Substrats (104), das dazu bestimmt ist, dem Sackloch (108) gegenüberliegend angeordnet zu werden, und/oder an der ersten Fläche (110) und/oder an der zweiten Fläche (112) des ersten Substrats (102),
- Ausbilden zumindest eines Kanals (116, 208, 214, 304), der dazu bestimmt ist, ein Innenraumvolumen des Sacklochs (108) mit einer Umgebung außerhalb der Verbindungsstruktur (100, 200, 300, 400) und/oder mit zumindest einem in der Verbindungsstruktur (100, 200, 300, 400) ausgebildeten Hohlraum (402) zu verbinden, dazu ausgelegt ist, eine Strömung von Luft oder Fluid, das in dem Innenraumvolumen des Sacklochs (108) vorhanden ist, über diesen Kanal (116, 208, 214, 304) herzustellen, und von dem zumindest ein Teil sich im Wesentlichen parallel zu zumindest einer der Flächen (110, 111, 112) des ersten (102) und/oder zweiten Substrats (104) erstreckt,
- festes Verbinden der ersten Fläche (110) des ersten Substrats (102) mit der Fläche (111) des zweiten Substrats (104).

12. Herstellungsverfahren nach Anspruch 11, wobei der Kanal (116, 208, 214, 304) und/oder der Hohlraum (402) in dem ersten Substrat (102) und/oder in dem zweiten Substrat (104) und/oder zwischen dem ersten Substrat (102) und dem zweiten Substrat (104) ausgebildet sind.

13. Herstellungsverfahren nach einem der Ansprüche 11 oder 12, wobei das erste Substrat (102) fest mit dem zweiten Substrat (104) über zumindest eine Dichtungsschnittstelle (106) verbunden wird, die separat vom ersten Substrat (102) und vom zweiten Substrat (104) vorliegt.

14. Herstellungsverfahren nach Anspruch 13, wobei die Ausbildung des Kanals (116, 208, 214, 304) zumindest durch Ausführen der nachfolgenden Schritte erhalten wird:
- Aufbringen einer Schicht (502) auf Basis von Dichtharz auf die erste Fläche (110) des ersten Substrats (102) und/oder auf die Fläche (111) des zweiten Substrats (104),
- Belichten der Schicht (502) auf Basis von Dichtharz durch eine Maske (504), die zumindest eine Gestalt aufweist, die derjenigen des auszubildenden Kanals (116, 208, 214, 304) entspricht,
- Entwickeln der Schicht (502) auf Basis von Dichtharz, wodurch die Dichtungsschnittstelle (106) und der Kanal (116, 208, 214, 304) gebildet werden.

15. Herstellungsverfahren nach Anspruch 13, wobei die Ausbildung des Kanals (116, 108, 214, 304) zumindest durch ein erfolgendes Aufbringen einer Klebstoffschicht auf die erste Fläche (110) des ersten Substrats (102) und/oder auf die Fläche (111) des zweiten Substrats (104) erhalten wird, wobei die Klebstoffschicht so strukturiert ist, dass sie zumindest eine Gestalt hat, die der Dichtungsschnittstelle (106) und dem auzubildenden Kanal (116, 208, 214, 304) entspricht.

16. Verfahren zum Metallisieren zumindest eines Sacklochs (108) einer Struktur (100, 200, 300, 400) nach einem der Ansprüche 1 bis 10, umfassend zumindest einen Schritt des Füllens des Sacklochs (108) mit zumindest einem elektrisch leitenden Material.

17. Metallisierungsverfahren nach Anspruch 16, wobei das Füllen des Sacklochs (108) die Durchführung eines Schritts zum Siebdruck von elektrisch leitendem Material auf die Struktur (100, 200, 300, 400) umfasst.

## Claims

1. A structure (100, 200, 300, 400) intended to be used for the making of at least one interconnection with at least one electric contact (114, 120, 122) including:
- at least one first substrate (102), whereof at least one first face (110) is made integral with at least one face (111) of at least one second substrate (104),
- at least one blind via (108) passing through the first substrate (102) and emerging at the first face (110) of the first substrate (102) and at a second face (112), opposite the first face (110), of the first substrate (102),
- the electric contact (114, 120, 122) arranged against said face (111) of the second substrate (104) and facing the blind via (108), and/or against the first face (110) and/or against the second face (112) of the first substrate (102),
- at least one channel (116, 208, 214, 304) putting the inner volume of the blind via (108) in communication with an environment outside the structure (100, 200, 300, 400) and/or with at least one cavity (402) formed in the structure (100, 200, 300, 400), adapted to create a circulation of air or of a fluid present in the inner volume of the via (108) through this channel (116, 208, 214, 304), and whereof at least a part extends substantially parallel to at least one of said faces (110, 111, 112) of the first (102) and/or second substrate (104).

2. The structure (100, 200, 300, 400) according to claim 1, wherein, when the electric contact (120, 122) is arranged against the first face (110) and/or against the second face (112) of the first substrate (102), said electric contact (120, 122) is arranged on the periphery of the blind via (108).

3. The structure (100, 200, 300, 400) according to one of the preceding claims, wherein the channel (116, 208, 214, 304) and/or the cavity (402) are formed in the first substrate (102) and/or in the second substrate (104) and/or between the first substrate (102) and the second substrate (104).

4. The structure (100, 200, 300, 400) according to one of the preceding claims, wherein the first substrate (102) is made integral with the second substrate (104) using a sealing interface (106) distinct from the first substrate (102) and the second substrate (104).

5. The structure (100, 200, 300, 400) according to claim 4, wherein the channel (116, 208, 214, 304) is formed by at least one space separating at least two portions (202, 204, 206, 302) of the sealing interface (106).

6. The interconnect structure (200, 300, 400) according to one of claims 4 or 5, wherein the sealing interface (106) includes a plurality of disjoined portions (206) of material arranged substantially on the periphery of the blind via (108).

7. The structure (200, 300) according to one of the preceding claims, also including at least one second blind via (108) passing through the first substrate (102) and emerging at the first face (110) and at the second face (112) of the first substrate (102), the channel (208, 214, 304) being able to make said inner volume of the blind via (108) communicate with the outside environment (200, 300) through the second blind via (108).

8. The structure (200) according to claim 7, wherein, when the first substrate (102) is made integral with the second substrate (104) using a sealing interface (106) distinct from the first substrate (102) and the second substrate (104), said channel (208, 214) is formed by at least one space (214) separating a first portion (202) of the sealing interface (106) from a second portion (204) of the sealing interface (106) whereof the pattern is included in an area defined by a pattern of the first portion (202) of the sealing interface (106).

9. The structure (400) according to one of claims 1 to 6, wherein the cavity (402) is formed by at least one space (402) separating a first portion (202) of the sealing interface (106) from a second portion (204) of the sealing interface (106) whereof the pattern is included in an area defined by a pattern of the first portion (202) of the sealing interface (106).

10. The structure (300) according to one of claims 1 to 7, also comprising a plurality of blind vias (108) passing through the first substrate (102) and emerging at the first face (110) and at the second face (112) of the first substrate (102), the channel (304) being able to make the blind vias (108) communicate with each other.

11. A method for making a structure (100, 200, 300, 400) intended to be used for the making of at least one interconnection with at least one electric contact (114, 120, 122), including at least the following steps:
- making at least one via (108) passing through at least a first substrate (102) and emerging at a first face (110) of the first substrate (102) and at a second face (112), opposite the first face (110), of the first substrate (102),
- making at least one electric contact (114, 120, 122) against a face (111) of a second substrate (104) and intended to be arranged opposite the via (108), and/or against the first face (110) and/or against the second face (112) of the first substrate (102),
- making at least one channel (116, 208, 214, 304) intended to put an inner volume of the via (108) in communication with an environment outside the interconnect structure (100, 200, 300, 400) and/or with at least one cavity (402) formed in the interconnect structure (100, 200, 300, 400), adapted to create a circulation of air or of a fluid present in the inner volume of the via (108) through this channel (116, 208, 214, 304), and at least one part of which extends substantially parallel to at least one of said faces (110, 111, 112) of the first (102) and/or second (104) substrate,
- making the first face (110) of the first substrate (102) integral with said face (111) of the second substrate (104).

12. The method according to claim 11, wherein the channel (116, 208, 214, 304) and/or the cavity (402) are made in the first substrate (102) and/or in the second substrate (104) and/or between the first substrate (102) and the second substrate (104).

13. The method according to one of claims 11 or 12, wherein the first substrate (102) is made integral with the second substrate (104) using at least one sealing interface (106) distinct from the first substrate (102) and the second substrate (104).

14. The method according to claim 13, wherein the making of the channel (116, 208, 214, 304) is obtained at least by carrying out the following steps:
- depositing a sealing resin-based layer (502) on the first face (110) of the first substrate (102) and/or on said face (111) of the second substrate (104);
- imaging the sealing resin-based layer (502) using a mask (504) comprising at least one pattern corresponding to that of the channel (116, 208, 214, 304) to be made;
- developing the sealing resin-based layer (502), forming the sealing interface (106) and the channel (116, 208, 214, 304).

15. The method according to claim 13, wherein the making of the channel (116, 208, 214, 304) is obtained at least by carrying out a deposition of a layer of glue on the first face (110) of the first substrate (102) and/or on said face (111) of the second substrate (104), the layer of glue being structured so as to have at least one pattern corresponding to the sealing interface (106) and the channel (116, 208, 214, 304) to be made.

16. A method for metalizing at least one blind via (108) of a structure (100, 200, 300, 400) according to one of claims 1 to 10, including at least one step for filling the blind via (108) with at least one electrically conducting material.

17. The metallization method according to claim 16, wherein the filling of the blind via (108) includes carrying out a serigraphy step of the electrically conducting material on the structure (100, 200, 300, 400).
